# EUROPÄISCHE PATENTSCHRIFT

(11) **EP 0 931 355 B1**
(45) Veröffentlichungstag und Bekanntmachung des Hinweises auf die Patenterteilung: **23.04.2003**
(21) Anmeldenummer: 97910216.7
(22) Anmeldetag: 19.09.1997
(51) Int. Cl.: H01L 29/92, H01L 21/3205

(54) **HALBLEITERANORDNUNG MIT GESCHÜTZTER BARRIERE FÜR EINE STAPELZELLE**
SEMICONDUCTOR DEVICE WITH A PROTECTED BARRIER FOR A STACK CELL
DISPOSITIF A SEMI-CONDUCTEUR DOTE D'UNE BARRIERE PROTEGEE POUR UNE CELLULE A EMPILEMENT

(30) Priorität: 30.09.1996 DE 19640246
(43) Veröffentlichungstag der Anmeldung: 28.07.1999
(73) Patentinhaber: Infineon Technologies AG, 81669 München (DE)
(72) Erfinder: HARTNER, Walter, D-89441 Medlingen (DE); SCHINDLER, Günther, D-80802 München (DE); MAZURE-ESPEJO, Carlos, D-85604 Zorneding (DE)
(74) Vertreter: Zimmermann & Partner
(86) Internationale Anmeldenummer: DE9702133
(87) Internationale Veröffentlichungsnummer: WO98015013

(56) Entgegenhaltungen:
- EP-A- 0 697 719
- US-A- 5 506 166

## Beschreibung

Die vorliegende Erfindung betrifft eine Halbleiteranordnung nach dem Oberbegriff des Patentanspruchs 1 sowie ein Verfahren zum Herstellen einer derartigen Halbleiteranordnung.

Herkömmliche Speicherelemente von Halbleiter-Speicheranordnungen verwenden als Speicherdielektrikum zumeist Siliziumdioxid- oder auch Siliziumnitridschichten, welche aber beide lediglich eine Dielektrizitätskonstante im Bereich von etwa 6 besitzen. Eine höhere Dielektrizitätskonstante würde jedoch zu einer größeren Kapazität des entsprechenden Kondensators führen, so daß auch dessen Abmessungen vermindert werden könnten, wenn auf eine entsprechende Steigerung der Kapazität verzichtet wird. Mit anderen Worten, die Verwendung eines Dielektrikums mit großer Dielektrizitätskonstante führt zu einer Verringerung der für den entsprechenden Kondensator benötigten Fläche und damit zu einer Steigerung der Integrationsdichte.

Die in diesem Zusammenhang durchgeführten Entwicklungen haben Materialien ergeben, die eine gegenüber 6 erheblich höhere Dielektrizitätskonstante aufweisen. So wurde beispielsweise als paraelektrisches Material (BaₓST₁₋ₓ)TiO₃ (BST) entwickelt, das eine Dielektrizitätskonstante in der Größenordnung von 400 hat. Es liegt auf der Hand, daß BST eine erhebliche Steigerung der Integrationsdichte erlaubt, wenn es anstelle der üblichen Siliziumdioxid- bzw. Siliziumnitridschichten eingesetzt wird.

Speicherelemente für Halbleiter-Speicheranordnungen mit Dielektrika, die eine hohe Dielektrizitätskonstanten aufweisen, werden z.B. in den Patentschriften US 5,506,166 und EP 0 697 719 offenbart. Die darin beschriebenen Stapelkondensatoren verwenden BST oder andere ferroelektrische oder paraelektrische Materialien als Dielektrikum.

Herkömmliche Speicherelemente, wie beispielsweise ein dynamischer Random-Speicher (DRAM), verwenden paraelektrische Materialien, die aber bei Ausfall der Versorgungsspannung ihre Ladung und somit auch die mit dieser gespeicherte Information verlieren. Außerdem müssen derartige herkömmliche Speicherelemente wegen des bei ihnen auftretenden Leckstromes ständig neu beschrieben werden, was als "refreshen" bezeichnet wird. Auch aus diesem Grund ist der Einsatz von neuartigen ferroelektrischen Materialien als Speicherdielektrikum wünschenswert, da nur so die Herstellung nichtflüchtiger Halbleiter-Speicheran-ordnungen möglich ist, die bei Ausfall der Versorgungsspannung nicht ihre Information verlieren und auch nicht ständig neu beschrieben werden müssen.

Zusammenfassend ergibt sich damit, daß bei Halbleiter-Speicheranordnungen der Einsatz ferroelektrischer Materialien als Speicherdielektrikum an sich wünschenswert ist, da so eine Steigerung der Integrationsdichte bei gleichzeitiger Sicherheit gegenüber einem Ausfall der Versorgungsspannung erreicht werden kann.

Die praktische Verwirklichung des Einsatzes derartiger ferroelektrischer oder auch paraelektrischer Materialien in Halbleiter-Speicheranordnungen hängt aber stark davon ab, wie sich diese Materialien in eine integrierte Halbleiter-Schaltungsanordnung einbauen lassen. Als solche ferroelektrische oder paraelektrische Materialien wurden bisher neben dem bereits erwähnten BST auch (Pb,Zr)TiO₃ (PZT), SrBi₂Ta₂O₉ (SBT), SrBi₂(Ta,Nb)O₉ (SBTN) SrTiO₃ (ST), ferro- und paraelektrische Polymere usw. bzw. allgemein ferro- und paraelektrische Materialien in Erwägung gezogen.

Obwohl diese Materialien hohe Dielektrizitätskonstanten aufweisen und aus diesem Grund auch schon bei ferroelektrischen Random-Speichern (FeRAM) eingesetzt werden, ist ihre Bedeutung in der Praxis noch begrenzt. Denn es hat sich gezeigt, daß die genannten Materialien mit hoher Dielektrizitätskonstante nicht ohne weiteres in Halbleiter-Speicheranordnungen eingesetzt werden können. So wird beispielsweise die Anwendung von dielektrischen Materialien mit hoher Dielektrizitätskonstante oder von Ferroelektrika in hoch integrierten Stapelzellen von Halbleiter-Speicheranordnungen stark dadurch behindert, daß der sogenannte "Plug" bzw. das in ein Kontaktloch eingebrachte Füllmaterial bei Abscheidung des Dielektrikums oxidiert wird. Diese Oxidation findet speziell aufgrund der Tatsache statt, daß es sich bei den genannten Dielektrika mit hoher Dielektrizitätskonstanten und Ferroelektrika um Oxide handelt, die bei der Herstellung der Halbleiter- bzw. Kondensatoranordnung hohen Temperaturen in einer sauerstoffhaitigen Atmosphäre ausgesetzt werden müssen.

Da die üblicherweise für den Kondensatorkontakt verwendete Platin-Elektrode Sauerstoffdurchlässig ist, oxidiert damit beispielsweise die Grenzfläche zwischen Plug und Elektrode, was mit einer elektrischen Unterbrechung gleichbedeutend ist.

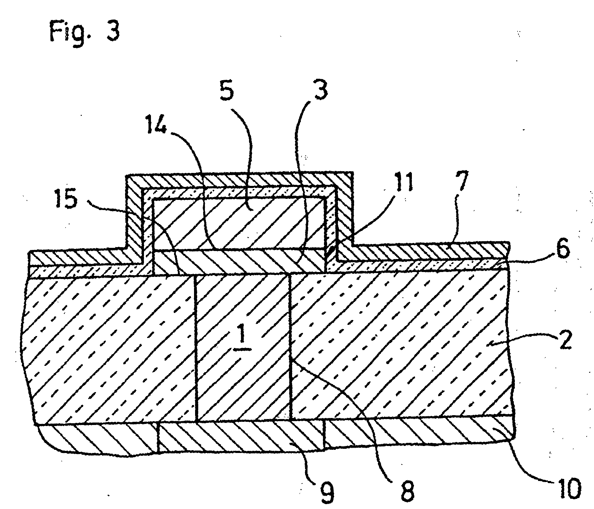

Figur 3 zeigt eine derartige Halbleiteranordnung mit einer Speicherzelle. Bei dieser Halbleiteranordnung ist auf einen Halbleiterkörper 10 mit einem hochdotierten Bereich 9 eine dielektrische Isolatorschicht 2 aus z.B. Siliziumdioxid aufgebracht, in die ein Loch 8 geätzt ist. Dieses Loch 8 ist mit einem Füllmaterial bzw. Plug 1 gefüllt, der aus Wolfram oder polykristallinem Silizium besteht. Oberhalb des Plugs 1 ist eine Barriereschicht 3 vorgesehen, die beispielsweise aus WN, TiWN, TaN, WC usw. bestehen kann. Die Barriereschicht 3 trennt eine untere Elektrode 5 z.B. aus Platin von dem Plug 1. Auf der unteren Elektrode 5 befindet sich ein paraelektrisches oder ferroelektrische Dielektrikum 6, auf das wiederum eine obere Elektrode 7 aufgetragen ist. Bei dieser Halbleiteranordnung tritt beginnend im Bereich 11 eine Oxidation des Materials der Barriereschicht 3 auf, was letztlich zu einer elektrischen Unterbrechung führen kann. Die Oxidation schreitet dabei vom Bereich 11 entlang der Grenzfläche 14 zwischen der Barriereschicht 3 und der Elektrode 5 und entlang der Grenzfläche 15 zwischen der Barriereschicht 3 und der Isolationsschicht 2 fort.

Nicht zuletzt aus diesem Grund wird bisher in der Praxis die Integration eines ferroelektrischen oder paraelektrischen Dielektrikums in einer Speicheranordnung bei hoher Integrationsdichte als wenig Erfolg versprechend angesehen.

Um die oben erwähnte Oxidation der Schnittfläche zwischen Elektrode und Plug in großem Umfang zu vermeiden, werden bisher Dielektrika mit hoher Dielektritzitätskonstanten oder Perroelektrika erst nach Fertigstellung einer herkömmlichen CMOS-Tränsistorstruktur über einem LOCOS-Gebiet planar abgeschieden. Mit anderen Worten, neben einem MOS-Transistor, dessen Drain beispielsweise mit einer Bitleitung verbunden und dessen Gate an eine Wortleitung angeschlossen ist, wird über dem LOCOS-Gebiet ein Kondensator vorgesehen, dessen obere Elektrode aus z.B. Platin besteht, das mit der Source-Elektrode eines MOS-Transistors verbunden ist, und dessen Isolierschicht aus einem Ferroelektrikum hergestellt ist, während die zweite Elektrode (common plate), die der ersten Elektrode durch das Ferroelektrikum gegenüberliegt, ebenfalls aus z.B. Platin hergestellt ist. Als Dielektrikum kann hierbei beispielsweise SBT verwendet werden. Die Größen der auf diese Weise gebildeten Speicherzellen betragen beispielsweise 10,1 µm x 16,5 µm = 167 µm² = 46 F², wenn für F ein Grundmaß von 1,9 µm herangezogen wird. Die Fläche des Kondensators beträgt dabei etwa 3,3 µm x 3,3 µm = 10,9 µm² = 3 F². Mit anderen Worten, es liegt ein relativ großer Platzbedarf für die Speicherzelle bzw. deren Verdrahtung zum Kondensator vor.

Vorteilhaft am Auftragen eines Kondensators über dem LOCOS-Ge-biet ist aber, daß zur Herstellung der planaren ferroelektrischen Schicht des Kondensators ein Sputter- oder Solgel-Ver-fahren benutzt werden kann und insbesondere durch das Aufbringen der ferroelektrischen Schicht, das in stark oxidierender Umgebung stattfindet, die Diffusion von Sauerstoff durch die meist aus Platin bestehende Elektrode hindurch die darunter liegende Schicht nicht mehr beeinträchtigt, da hier bereits ein Oxid vorliegt.

Zusammenfassend ergibt sich damit, daß das Abscheiden einer CMOS-Transistorstruktur über dem LOCOS-Gebiet zwar ohne weiters möglich ist, jedoch zu einer erheblichen Verminderung der Integrationsdichte führt.

Ein direktes Auftragen der ferroeiektrischen Schichten über dem elektrisch leitenden Plug ist zwar möglich, führt aber zu einer weiteren Oxidation und damit letztlich zu einer Isolation der elektrischen Verbindungen.

Es ist daher **Aufgabe** der vorliegenden Erfindung, eine Halbleiteranordnung zu schaffen, die eine Integration von Bauelementen mit ferroelektrischen und paraelektrischen Materialien erlaubt und bei der unerwünschte Oxidationen im Bereich der Barriereschicht des Plugs zuverlässig vermieden sind; außerdem soll ein Verfahren zum Herstellen einer derartigen Halbleiteranordnung angegeben werden.

Zur Lösung dieser Aufgabe sieht die vorliegende Erfindung eine Halbleiteranordnung mit den Merkmalen des Patentanspruches 1 vor. Außerdem wird ein Verfahren mit den Merkmalen des Patentanspruches 5 geschaffen.

Vorteilhafte Weiterbildungen der Erfindung ergeben sich insbesondere aus den Patentansprüchen 2 bis 4.

Bei der erfindungsgemäßen Halbleiteranordnung ist also die Barriereschicht in einen "Siliziumnitridkragen", der durch die Siliziumnitridschicht gebildet ist, eingebettet. Dadurch wird das Material der Barriereschicht, also beispielsweise Tiannitrid, Wolframnitrid, Titanwolframnitrid, Tantalnitrid usw., vor einer Oxidation zuverlässig geschützt.

Durch den "Siliziumnitridkragen" wird eine laterale Sauerstoff-Diffusion bei der Herstellung des paraelektrischen oder ferroelektrischen Dielektrikums vermieden. Das heißt, es tritt praktisch keine laterale Oxidation der Barriereschicht auf, wie dies beim Stand der Technik der Fall ist. Außerdem wird erreicht, daß das Material, z.B. Platin, der unteren Elektrode gut auf der Siliziumnitridschicht haftet.

Nachfolgend wird die Erfindung anhand der Zeichnungen näher erläutert. Es zeigen:
- Fig. 1: einen Schnitt durch ein erstes Ausführungsbeispiel der erfindungsgemäße Halbleiteranordnung;
- Fig. 2: einen Schnitt durch ein zweites Ausführungsbeispiel der erfindungsgemäßen Halbleiteranordnung und
- Fig. 3: einen Schnitt durch eine bestehende Halbleiteranordnung.

In den Figuren sind einander entsprechende Bauteile jeweils mit den gleichen Bezugszeichen versehen.

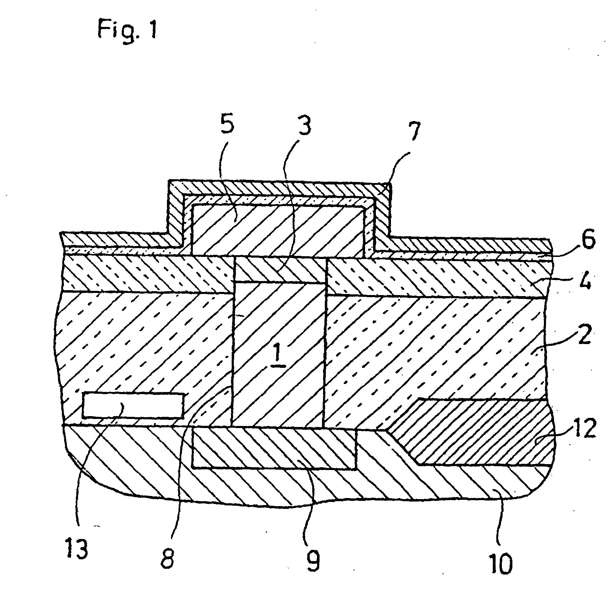

Wie in einem ersten Ausführungsbeispiel in Fig. 1 gezeigt ist, befindet sich bei der erfindungsgemäßen Halbleiteranordnung auf einem Siliziumsubstrat 10 mit einem hochdotierten Bereich 9 eine Siliziumdioxidschicht 2, die ein Kontaktloch 8 zu dem hochdotierten Bereich 9 aufweist. In der Siliziumdioxidschicht 2 bzw. auf dem Siliziumsubstrat 10 können noch weitere leitende oder hochdotierte Bereiche 13 und Isolationsbereiche 12 vorgesehen sein. Diese hochdotierten Bereiche 13, 12 können beispielsweise Leiterbahnen oder LOCOS sein.

Das Kontaktloch 8 ist mit Füllmaterial bzw. Plug 1 versehen. Zwischen dem Plug 1, dessen leitendes Material aus z.B. Wolfram, Silizium, Nitriden oder polykristallinem Silizium besteht, und einer unteren Elektrode 5 aus z.B. Platin ist eine Barriereschicht 3 angeordnet, die aus leitenden Nitriden, Karbiden, Boriden usw., wie z.B. WN, WC, WTiN, TaN, TiN, TiC usw. hergestellt sein kann. Ein mögliches Material für den Plug 1 ist beispielsweise WSi. Die Barriereschicht 3 wird seitlich von einer Siliziumnitridschicht 4 umgeben, deren Oberseite in der gleichen Ebene wie die Oberseite der Barriereschicht 3 liegt. Die Oberseite der Barriereschicht 3 kann aber auch etwas unterhalb der Oberseite der Siliziumnitridschicht 4 liegen. Auf die untere Elektrode 5 aus Platin ist ein paraelektrisches, superparaelektrisches oder ferroelektrisches Dielektrikum 6 aufgetragen, welches wiederum mit einer oberen Elektrode 7 bedeckt ist. Die obere Elektrode 7 und/oder die untere Elektrode 5 können auch aus Ruthenium, Iridium, Palladium oder leitenden Oxiden hiervon, wie RuO₂, IrO₂ usw. bestehen.

Die Herstellung der erfindungsgemäßen Halbleiteranordnung kann beispielsweise in der folgenden Weise geschehen:

Zunächst wird die CMOS-Ebene mit dem Halbleiterkörper 10, den hochdotierten Bereichen 9 und 13, dem Isolationsbereich 12 und der Siliziumdioxidschicht 2 hergestellt. Vor Ätzung des Kontaktloches 8 wird sodann die Siliziumnitridschicht 4 abgeschieden.

Nach Ätzung des Kontaktloches 8 und Auffüllung des Kontaktloches 8 mit Wolfram, leitendem Material, wie Siliziden oder polykristallinem Silizium erfolgt eine Rückätzung zur Bildung einer Aussparung im oberen Bereich des Plugs 1. Die Tiefe dieser Rückätzung ist etwa an die Dicke der SiliziumnitridSchicht so angepaßt, daß sie etwas kleiner als die Dicke der Siliziursmitridschicht 4 ist. Sodann wird durch Sputtern oder MOCVD die Barriereschicht 3 im Bereich der Rückätzung aufgebracht. Durch beispielsweise einen Rückätz- oder Schleifprozeß wird die Oberfläche der Barriereschicht 3 mit der Oberfläche der Siliziumnitridschicht 4 ausgerichtet. Mit anderen Worten, die Siliziumnitridschicht 4 umgibt wie ein "Kragen" die Barriereschicht 3.

Auf die Barriereschicht 3 wird die untere Elektrode 5, die bevorzugt aus Platin besteht, aufgetragen. Sodann wird das paraelektrische, superparaelektrische oder ferroelektrische Dielektrikum 6 aufgebracht und strukturiert. Die Barriereschicht 3 wirkt während des Abscheidens des Dielektrikums 6 sowie bei den nachfolgenden oxidierenden Temperaturprozessen als Schutz gegen eindiffundierenden Sauerstoff und verhindert die Oxidation des Plugs 1. Die Siliziumnitridschicht 4 schützt dabei die eingebettete Barriereschicht 3 zuverlässig vor der Oxidation und gewährleistet die Integrität der Platin/Barriereschicht/Plug/ Struktur. Siliziumnitrid ist bekanntlich eine gute Sauerstoff-Diffusionsbarriere, die die Zufuhr von Sauerstoff im vorliegenden Fall zum Übergangsbereich zwischen Barriereschicht und unterer Elektrode aus der Umgebung verhindert.

Die vorliegende Erfindung erhöht damit den Oxidationswiderstand der Barriereschicht 3 in großem Ausmaß.

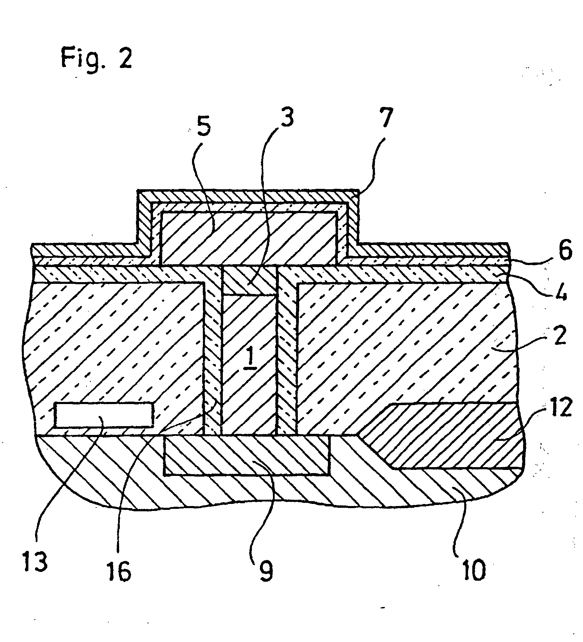

Fig. 2 zeigt ein weiteres Ausführungsbeispiel der Erfindung. Bei diesem Ausführungsbeispiel ist die Wand des Kontaktloches 8 mit einer Zusatz-Siliziumnitridschicht 16 bedeckt, die nach der Ätzung des Kontaktloches 8 abgeschieden wird.

## Patentansprüche

1. Halbleiteranordnung für integrierte Schaltungen, insbesondere Speicher, in DRAM- und FeRAM-Technik, bei der eine Stapelzelle in einer Isolierschicht (2) ein mit einem Füllmaterial bzw. Plug (1) gefülltes Kontaktloch (8) aufweist, auf dem ein Kondensator mit einer unteren, dem Füllmaterial (1) zugewandten Elektrode (5), einem superparaelektrischen oder paraelektrischen oder ferroelektrischen Dielektrikum (6) und einer oberen Elektrode (7) vorgesehen ist, wobei zwischen dem Füllmaterial (1) und der unteren Elektrode (5) eine das Füllmaterial und die unter Elektrode elektrisch kontaktierende Barriereschicht (3) vorgesehen ist, die von Bereichen aus Siliziumnitrid vollständig umgeben ist,
**dadurch gekennzeichnet,**
**daß** die Barriereschicht (3) in dem Kontaktloch (8) auf dem Füllmaterial (1) angeordnet ist,
**daß** die Bereiche aus Siliziumnitrid von einer auf der Isolierschicht (2) angeordneten Siliziumnitridschicht (4) gebildet sind,
**daß** die Siliziumnitridschicht (4) an das Kontaktloch (8) angrenzt und eine weitere Siliziumnitridschicht (16) an der Wand des Kontaktlochs ausgebildet ist, und
**daß** auf einer von der Barriereschicht (3) und der Siliziumnitridschicht (4) gebildeten Ebene die untere Elektrode (5), das Dielektrikum (6) und die obere Elektrode (7) angeordnet sind.

2. Halbleiteranordnung nach Anspruch 1,
**dadurch gekennzeichnet, daß** das Füllmaterial aus leitenden Materialien, insbesondere aus Siliziden, Nitriden, Wolfram oder polykristallinem Silizium besteht.

3. Halbleiteranordnung nach Anspruch 1 oder 2,
**dadurch gekennzeichnet,**
**daß** die untere Elektrode (5) und/oder die obere Elektrode (7) aus Platin, Ruthenium, Iridium, Palladium oder leitenden Oxiden hiervon bestehen.

4. Halbleiteranordnung nach einem der Ansprüche 1 bis 3,
**dadurch gekennzeichnet,**
**daß** die Barriereschicht (3) aus WN, WC, WTiN, TaN, TiN oder TiC besteht.

5. Verfahren zur Herstellung der Halbleiteranordnung nach einem der Ansprüche 1 bis 4,
**dadurch gekennzeichnet,**
**daß** nach Herstellung einer CMOS-Ebene mit einem Halbleiterkörper (10) auf diesem eine Isolierschicht (2) erzeugt und eine Siliziumnitridschicht (4) aufgetragen wird,
**daß** in die Siliziumnitridschicht (4) und die Isolierschicht (2) ein Kontaktloch (8) eingebracht wird,
**daß** nach Ätzung des Kontaktloches (8) auf dessen Wand eine Siliziumnitridschicht (16) abgeschieden wird,
**daß** das Kontaktloch (8) mit leitendem Füllmaterial (1), insbesondere aus Siliziden, Nitriden, Wolfram oder polykristallinem Silizium, aufgefüllt wird,
**daß** in dem Füllmaterial (1) eine Aussparung erzeugt wird, die eine an die Dicke der Siliziumnitridschicht (4) angepaßte Tiefe hat,
**daß** in der Aussparung eine Barriereschicht (3) erzeugt wird, daß die Barriereschicht (3) durch einen Schleif- oder Rückätzprozeß in die Siliziumnitridschicht (4) eingebettet wird, und
**daß** nacheinander die untere Elektrode (5), das Dielektrikum (6) und die obere Elektrode (7) aufgebracht werden.

## Claims

1. Semiconductor arrangement for integrated circuits, in particular memories, using DRAM and FeRAM technology, in which a stacked cell has a contact hole (8) filled with a filling material or plug (1) in an insulating layer (2), a capacitor having a lower electrode (5), which faces the filling material (1), a superparaelectric or paraelectric or ferroelectric dielectric (6) and an upper electrode (7) being provided on said contact hole or plug, and a barrier layer (3) being provided between the filling material (1) and the lower electrode (5), which barrier layer establishes electrical contact between the filling material and the lower electrode and is completely surrounded by regions of silicon nitride,
**characterized**
**in that** the barrier layer (3) is arranged in the contact hole (8) on the filling material (1),
**in that** the regions of silicon nitride are formed by a silicon nitride layer (4) arranged on the insulating layer (2),
**in that** the silicon nitride layer (4) adjoins the contact hole (8) and a further silicon nitride layer (16) is formed on the wall of the contact hole, and
**in that** the lower electrode (5), the dielectric (6) and the upper electrode (7) are arranged on a plane formed by the barrier layer (3) and the silicon nitride layer(4).

2. Semiconductor arrangement according to Claim 1,
**characterized**
**in that** the filling material comprises conductive materials, in particular silicides, nitrides, tungsten or polycrystalline silicon.

3. Semiconductor arrangement according to Claim 1 or 2,
**characterized**
**in that** the lower electrode (5) and/or the upper electrode (7) comprise/comprises platinum, ruthenium, iridium, palladium or conductive oxides thereof.

4. Semiconductor arrangement according to one of Claims 1 to 3,
**characterized**
**in that** the barrier layer (3) is composed of WN, WC, WTiN, TaN, TiN or TiC.

5. Method for fabricating the semiconductor arrangement according to one of Claims 1 to 4,
**characterized**
**in that** after the fabrication of a CMOS plane with a semiconductor body (10), an insulating layer (2) is produced on said semiconductor body and a silicon nitride layer (4) is applied,
**in that** a contact hole (8) is made in the silicon nitride layer (4) and the insulating layer (2),
**in that** after the contact hole (8) has been etched, a silicon nitride layer (16) is deposited on the wall of said contact hole,
**in that** the contact hole (8) is filled with conductive filling material (1), in particular made of silicides, nitrides, tungsten or polycrystalline silicon,
**in that** a recess is produced in the filling material (1), said recess having a depth matched to the thickness of the silicon nitride layer (4),
**in that** a barrier layer (3) is produced in the recess,
**in that** the barrier layer (3) is embedded in the silicon nitride layer (4) by means of a grinding or etching-back process, and
**in that** the lower electrode (5), the dielectric (6) and the upper electrode (7) are applied one after the other.

## Revendications

1. Dispositif à semi-conducteur pour des circuits intégrés, notamment pour des mémoires en technique DRAM et en technique-FeRAM, dans lequel une cellule à empilement comprend dans une couche (2) isolante un trou (8) métallisé empli d'une matière de charge ou de plug (1), trou sur lequel est prévu un condensateur ayant une électrode (5) inférieure tournée vers la matière (1) de charge, un diélectrique (6) supraparaélectrique ou para électrique ou ferroélectrique et une électrode (7) supérieure, une couche (3) barrière mettant en contact électriquement la matière de charge et l'électrode inférieure étant prévue entre la matière (1) de charge et l'électrode (5) inférieure et étant entourée entièrement de zones en nitrure de silicium,
**caractérisé,**
**en ce que** la couche (3) barrière est placée dans le trou (8) métallisé sur la matière (1) de charge,
**en ce que** les zones de nitrure de silicium sont formées par une couche (4) de nitrure de silicium placée sur la couche (2) isolante,
**en ce que** la couche (4) de nitrure de silicium est adjacente au trou (8) métallisé et une couche (16) supplémentaire de nitrure de silicium est formée sur la paroi du trou métallisé, et
**en ce que** l'électrode (5) inférieure, le diélectrique (6) et l'électrode (7) supérieure sont placés dans un plan formé par la couche (3) barrière et la couche (4) de nitrure de silicium.

2. Dispositif à semi-conducteur suivant la revendication 1,
**caractérisé,**
**en ce que** la matière de charge est en matière conductrice notamment en siliciures, nitrures, tungstène ou silicium polycristallin.

3. Dispositif à semi-conducteur suivant la revendication1 ou 2,
**caractérisé,**
**en ce que** l'électrode (5) inférieure et/ou l'électrode (7) supérieure sont en platine, en ruthénium, en iridium, en palladium ou en leurs oxydes conducteurs.

4. Dispositif à semi-conducteur suivant l'une des revendication 1 à 3,
**caractérisé,**
**en ce que** la couche (3) barrière est en WN, WC, WTiN, TaN, TiN ou TiC.

5. Procédé de production d'un dispositif à semi-conducteur selon l'une des revendications 1 à 4,
**caractérisé,**
**en ce qu'**après la production d'un plan CMOS ayant un corps (10) semi conducteur, on produit sur celui-ci une couche (2) isolante et on dépose une couche (4) de nitrure de silicium,
on ménage un trou (8) métallisé dans la couche (4) de nitrure de silicium et la couche (2) isolante,
après avoir ménagé le trou (8) métallisé par une attaque, on dépose sur sa paroi une couche (16) de nitrure de silicium,
on emplit le trou (8) métallisé de matière (1) de charge conductrice, notamment en siliciures, nitrures, tungstène ou silicium polycristallin,
on produit dans la matière (1) de charge un évidement qui a une profondeur adaptée à l'épaisseur de la couche (4) de nitrure de silicium,
on produit dans l'évidement une couche (3) barrière,
on incorpore la couche (3) barrière par une opération de rodage ou d'attaque en retour dans la couche (4) de nitrure de silicium et on dépose successivement l'électrode (5) inférieure, le diélectrique (6) et l'électrode (7) supérieure.
